# FASCICULE DE BREVET EUROPEEN

(11) **EP 3 080 815 B1**
(45) Date de publication et mention de la délivrance du brevet: **22.11.2023**
(21) Numéro de dépôt: 14815648.2
(22) Date de dépôt: 12.12.2014
(51) Int. Cl.: G11C 13/00, G11C 16/34, G06F 12/02

(54) **SYSTÈME ET PROCÉDÉ DE GESTION DE L'USURE D'UNE MÉMOIRE ÉLECTRONIQUE**
SYSTEM UND VERFAHREN ZUR VERWALTUNG DES VERSCHLEISSES EINES ELEKTRONISCHEN SPEICHERS
SYSTEM AND METHOD FOR MANAGING WEAR OF AN ELECTRONIC MEMORY

(30) Priorité: 12.12.2013 FR 1362471
(43) Date de publication de la demande: 19.10.2016
(73) Titulaire: Commissariat à l'Energie Atomique et aux Energies Alternatives, 75015 Paris (FR)
(72) Inventeur: HARRAND, Michel, 38120 Saint Egreve (FR); VIANELLO, Elisa, 38000 Grenoble (FR)
(74) Mandataire: Cabinet Beaumont
(86) Numéro de dépôt international: PCT/EP2014/077653
(87) Numéro de publication internationale: WO 2015/086847

(56) Documents cités:
- EP-A1- 1 345 234
- WO-A1-2011/133139
- WO-A1-2013/140754
- US-A1- 2004 022 085
- US-A1- 2004 047 228
- US-A1- 2010 058 018
- US-B1- 6 320 778

## Description

La présente demande de brevet revendique la priorité de la demande de brevet français FR13/62471.

### Domaine

La présente demande concerne le domaine des mémoires électroniques de façon générale, et vise plus particulièrement la gestion de l'usure dans une mémoire résistive non volatile.

### Exposé de l'art antérieur

Dans la présente demande, on désigne par mémoire, dispositif mémoire, ou mémoire électronique un dispositif comportant une pluralité de cellules élémentaires de mémorisation, chaque cellule pouvant être programmée pour stocker un ou plusieurs bits de données (un bit si l'élément de stockage de la cellule peut prendre deux états distincts, et plusieurs bits si l'élément de stockage de la cellule peut prendre plus de deux états distincts). En pratique, une mémoire peut contenir un très grand nombre de cellules élémentaires, typiquement plusieurs millions à plusieurs centaines de milliards.

On s'intéresse ici plus particulièrement aux mémoires dites résistives, c'est-à-dire dans lesquelles chaque cellule élémentaire de mémorisation comprend un élément dont on peut modifier la résistance en lui appliquant une tension de polarisation. Parmi les mémoires résistives les plus répandues, on peut notamment citer :
les mémoires à changement de phase, généralement désignées dans la technique par l'acronyme PCM (de l'anglais "Phase Change Memory"), dans lesquelles l'élément résistif est réalisé à l'aide d'un matériau dont on peut changer l'état cristallin et par conséquent la résistivité, en faisant varier sa température pendant une écriture ;
les mémoires à pont conducteur, généralement désignées dans la technique par l'acronyme CBRAM (de l'anglais "Conductive Bridge Random Access Memory"), dans lesquelles l'élément résistif est réalisé à l'aide d'un matériau isolant dans lequel un filament conducteur peut être créé ou supprimé par application d'une tension de polarisation ; et
les mémoires à oxydation-réduction, généralement désignées dans la technique par l'acronyme OxRRAM (de l'anglais "Oxyde-based Résistive Random Access Memory"), dans lesquelles l'élément résistif est aussi réalisé à l'aide d'un matériau isolant dans lequel un filament conducteur peut être créé ou supprimé par application d'une tension de polarisation.

Les mémoires résistives sont des mémoires non volatiles, c'est-à-dire qu'elles peuvent conserver les données qu'elles contiennent même en l'absence d'alimentation électrique. Elles présentent en outre de bonnes performances en termes de vitesse et de consommation électrique, par exemple des performances du même ordre de grandeur voire supérieures à celles des mémoires capacitives volatiles désignées dans la technique par le sigle DRAM (de l'anglais "Dynamic Random Access Memory"), qui sont largement utilisées dans de nombreux systèmes électroniques. De plus, les mémoires résistives présentent un encombrement relativement faible, et notamment inférieur à celui des mémoires DRAM (à capacité de stockage de données identique).

Dans de nombreux systèmes électroniques, il serait avantageux de pouvoir remplacer des mémoires de type DRAM par des mémoires résistives, pour tirer profit notamment de la non volatilité et de la densité élevée des mémoires résistives.

Toutefois, un problème qui se pose est que les cellules élémentaires des mémoires résistives ont une durée de vie ou endurance relativement faible par rapport aux mémoires DRAM. A titre d'exemple illustratif, le nombre maximum de cycles, c'est-à-dire le nombre maximum de lecture ou écriture, que peut typiquement supporter une cellule élémentaire d'une mémoire résistive est de l'ordre de 10⁸, alors que ce nombre est quasiment infini pour une mémoire DRAM.

Ainsi, pour pouvoir utiliser des mémoires résistives dans des applications mettant en oeuvre des accès fréquents à la mémoire, par exemple comme mémoire vive dans un ordinateur, une tablette numérique, un smartphone, etc., il convient de prévoir des mécanismes de contrôle de l'usure de la mémoire, permettant d'augmenter sa durée de vie.

Les documents US2004/047228, WO2011/133139, US2010/058018, EP1345234, US2004/022085 et WO2013/140754 décrivent des exemples de systèmes de gestion de mémoires.

### Résumé

La présente invention prévoit un système comportant : une mémoire résistive non volatile comprenant une pluralité de pages; et un circuit de contrôle adapté à effectuer des accès utilisateur à la mémoire et à mettre en oeuvre un procédé de gestion de l'usure de la mémoire,caractérisé en ce que le circuit de contrôle est configuré pour effectuer, entre des première et deuxième opérations consécutives de lecture ou d'écriture de page du procédé de gestion d'usure, et entre la deuxième opération et une troisième opération consécutive de lecture ou d'écriture de page du procédé de gestion d'usure, un ou plusieurs accès utilisateur à des pages de la mémoire, aucune autre opération de lecture ou d'écriture de page du procédé de gestion d'usure n'étant effectuée entre les première et deuxième opérations et entre les deuxième et troisième opérations,le système comportant en outre des éléments de stockage intermédiaire de données, le circuit de contrôle étant configuré pour, lors de la mise en oeuvre du procédé de gestion d'usure, mémoriser temporairement dans lesdits éléments de stockage des données de la mémoire, et, lorsqu'un accès utilisateur en lecture ou en écriture survient, vérifier si les données visées par l'utilisateur sont contenues dans lesdits éléments de stockage, et, si elles le sont, traiter l'accès utilisateur directement dans lesdits éléments de stockage. Des aspects préférés sont définis dans les revendications dépendantes 2 à 16.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente de façon schématique un exemple d'organisation ou d'agencement de cellules élémentaires de stockage de données dans une mémoire ;
les figures 2A à 2F illustrent de façon schématique des exemples de mécanismes ou procédés de gestion de l'usure d'une mémoire ;
la figure 3 représente de façon schématique un exemple de réalisation d'un dispositif d'adressage d'une mémoire susceptible d'être utilisé dans un système mettant en oeuvre des procédés de gestion d'usure du type décrit en relation avec les figures 2A à 2F ; et
la figure 4 représente de façon schématique et partielle un exemple d'un mode de réalisation d'un système comportant une mémoire et des moyens de mise en oeuvre d'un procédé de gestion de l'usure de cette mémoire.

### Description détaillée

Par souci de clarté, de mêmes éléments ont été désignés par de mêmes références aux différentes figures. En outre, seuls les éléments utiles à la compréhension des modes de réalisation décrits ont été représentés et seront détaillés par la suite. En particulier, des modes de réalisation de systèmes comportant une mémoire et des moyens de mise en oeuvre de procédés de gestion de l'usure de cette mémoire ont été représentés et seront détaillés. Toutefois, les diverses utilisations qui peuvent être faites de la mémoire de tels systèmes n'ont pas été détaillées, les modes de réalisation décrits étant compatibles avec les utilisations usuelles d'une mémoire.

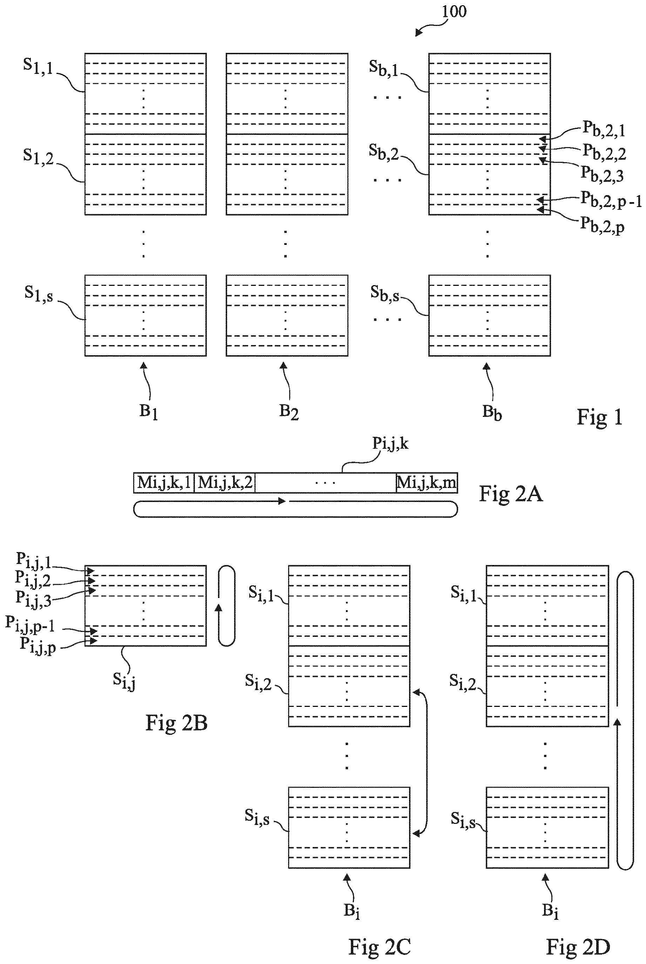

La figure 1 représente de façon schématique un exemple d'agencement de cellules élémentaires de stockage de données (non visibles sur la figure) dans une mémoire 100, par exemple une mémoire résistive. Dans cet exemple, les cellules élémentaires de la mémoire 100 sont réparties en plusieurs bancs Bᵢ, avec i entier allant de 1 à b et b entier supérieur à 1, les cellules de chaque banc Bᵢ sont réparties en plusieurs segments S_{i,j}, avec j entier allant de 1 à s et s entier supérieur à 1, les cellules de chaque segment S_{i,j} sont réparties en plusieurs lignes ou pages P_{i,j,k}, avec k entier allant de 1 à p et p entier supérieur à 1, et les cellules de chaque page P_{i,j,k} sont réparties en plusieurs mots M_{i,j,k,l}, avec l entier allant de 1 à m et m entier supérieur à 1, de plusieurs cellules élémentaires chacun. Chaque page P_{i,j,k} correspond par exemple à la plus grande quantité de mémoire adressable en un seul cycle mémoire, c'est-à-dire le plus grand groupe de cellules élémentaires qui peut être lu ou écrit en un seul cycle dans la mémoire. A titre d'exemple illustratif non limitatif, la mémoire 100 est une mémoire de 32 Giga-bits, organisée en 32 bancs comportant chacun 512 segments, chaque segment comportant 4096 pages comportant chacune 16 mots de 32 cellules élémentaires (32 bits).

En pratique, dans la plupart des systèmes électroniques utilisant une mémoire, la répartition des accès en lecture et/ou en écriture à l'intérieur de la mémoire est très inégale. En effet, certaines données stockées dans la mémoire sont utilisées beaucoup plus fréquemment que d'autres. Les portions de mémoire contenant les données les plus fréquemment utilisées s'usent plus rapidement que les autres, et leur durée de vie conditionne généralement la durée de vie de l'intégralité de la mémoire.

Pour augmenter la durée de vie d'une mémoire, on peut prévoir, lorsqu'une portion de la mémoire a été écrite plus d'un certain nombre de fois, de déplacer les données contenues dans cette portion de la mémoire soit à l'intérieur de la portion elle-même, soit vers une autre portion de la mémoire. De tels déplacements de données permettent de mieux répartir les accès aux cellules physiques de la mémoire, et ainsi d'équilibrer l'usure de la mémoire et donc d'augmenter sa durée de vie. Pour que ces déplacements de données soient transparents pour l'utilisateur de la mémoire, on peut prévoir un dispositif de conversion d'adresses dites logiques ou adresses utilisateur, qui sont les adresses dont se sert l'utilisateur pour accéder à la mémoire, en adresses dites physiques, qui sont les adresses où sont effectivement physiquement mémorisées les données sur lesquelles pointent les adresses utilisateur.

La figure 2A illustre schématiquement un premier exemple de procédé de gestion ou d'équilibrage d'usure qui peut être mis en oeuvre dans la mémoire 100 de la figure 1.

Dans cet exemple, les accès à chaque page P_{i,j,k} de la mémoire sont comptés, et, lorsque le nombre d'accès à une page P_{i,j,k} de la mémoire dépasse un seuil, une rotation circulaire interne des données de cette page est mise en oeuvre, c'est-à-dire que les contenus des mots M_{i,j,k,l} de la page subissent une rotation circulaire à l'intérieur de la page. A titre d'exemple, le contenu du premier mot M_{i,j,k,1} de la page est transféré dans le deuxième mot M_{i,j,k,2} de la page, le contenu du deuxième mot M_{i,j,k,2} de la page est transféré dans le troisième mot M_{i,j,k,3} de la page, et ainsi de suite jusqu'au dernier mot M_{i,j,k,m} de la page dont le contenu est transféré dans le premier mot M_{i,j,k,1} de la page.

La figure 2B illustre schématiquement un deuxième exemple de procédé de gestion ou d'équilibrage d'usure qui peut être mis en oeuvre dans la mémoire 100 de la figure 1.

Dans cet exemple, après un certain nombre d'accès à un segment S_{i,j} de la mémoire, une rotation circulaire interne des données de ce segment est mise en oeuvre, c'est-à-dire que les contenus des pages P_{i,j,k} du segment subissent une rotation circulaire à l'intérieur du segment. A titre d'exemple, le contenu de la première page P_{i,j,1} du segment est transféré dans la deuxième page P_{i,j,2} du segment, le contenu de la deuxième page P_{i,j,2} du segment est transféré dans la troisième page P_{i,j,3} du segment, et ainsi de suite jusqu'à la dernière page P_{i,j,p} du segment dont le contenu est transféré dans la première page P_{i,j,1} du segment.

A titre d'exemple, les accès à chaque segment S_{i,j} de la mémoire peuvent être comptés, et, lorsque le nombre d'accès à un segment S_{i,j} de la mémoire dépasse un seuil, une rotation circulaire interne peut être appliquée à ce segment. A titre de variante, si le procédé de la figure 2A est mis en oeuvre, une rotation circulaire interne peut être appliquée à un segment S_{i,j} lorsqu'une même page de ce segment a subi un certain nombre de rotations circulaires internes, par exemple égal au nombre de mots de la page, c'est-à-dire lorsque le contenu de chaque mot M_{i,j,k,l} de la page a retrouvé l'emplacement physique qu'il occupait avant la première rotation circulaire interne de la page.

La figure 2C illustre schématiquement un troisième exemple de procédé de gestion ou d'équilibrage d'usure qui peut être mis en oeuvre dans la mémoire 100 de la figure 1.

Dans cet exemple, après un certain nombre d'accès à un segment S_{i,j} de la mémoire, le contenu de ce segment est permuté avec le contenu d'un autre segment du même banc Bᵢ de la mémoire, par exemple un segment ayant subi un nombre d'accès moins important, par exemple le segment du banc Bᵢ ayant subi le nombre d'accès le plus faible.

A titre d'exemple, les accès à chaque segment S_{i,j} de la mémoire peuvent être comptés, et, lorsque le nombre d'accès à un segment S_{i,j} de la mémoire dépasse un seuil, une permutation du contenu de ce segment avec le contenu d'un autre segment du même banc peut être effectuée. A titre de variante, si le procédé de la figure 2B est mis en oeuvre, une permutation du contenu d'un segment S_{i,j} avec le contenu d'un autre segment du même banc peut être effectuée lorsque le segment S_{i,j} a subi un certain nombre de rotations circulaires internes, par exemple égal au nombre de pages de ce segment.

La figure 2D illustre schématiquement un quatrième exemple de procédé de gestion ou d'équilibrage d'usure qui peut être mis en oeuvre dans la mémoire 100 de la figure 1.

Dans cet exemple, après un certain nombre d'accès à un banc Bᵢ de la mémoire, une rotation circulaire interne des données de ce banc est mise en oeuvre, c'est-à-dire que les segments S_{i,j} du banc subissent une rotation circulaire à l'intérieur du banc. A titre d'exemple, le contenu du premier segment S_{i,1} du banc est transféré dans le deuxième segment S_{i,2} du banc, le contenu du deuxième segment S_{i,2} du banc est transféré dans le troisième segment S_{i,3} du banc, et ainsi de suite jusqu'au dernier segment S_{i,s} du banc dont le contenu est transféré dans le premier segment S_{i,1} du banc.

A titre d'exemple, les accès à chaque banc Bᵢ de la mémoire peuvent être comptés, et, lorsque le nombre d'accès à un banc Bᵢ de la mémoire dépasse un seuil, ce banc peut subir une rotation circulaire interne. A titre de variante, si le procédé de la figure 2B est mis en oeuvre à l'intérieur des segments de la mémoire, un banc Bᵢ peut subir une rotation circulaire interne lorsqu'un même segment S_{i,j} de ce banc a subi un certain nombre de rotations circulaires internes, par exemple égal au nombre de pages de ce segment.

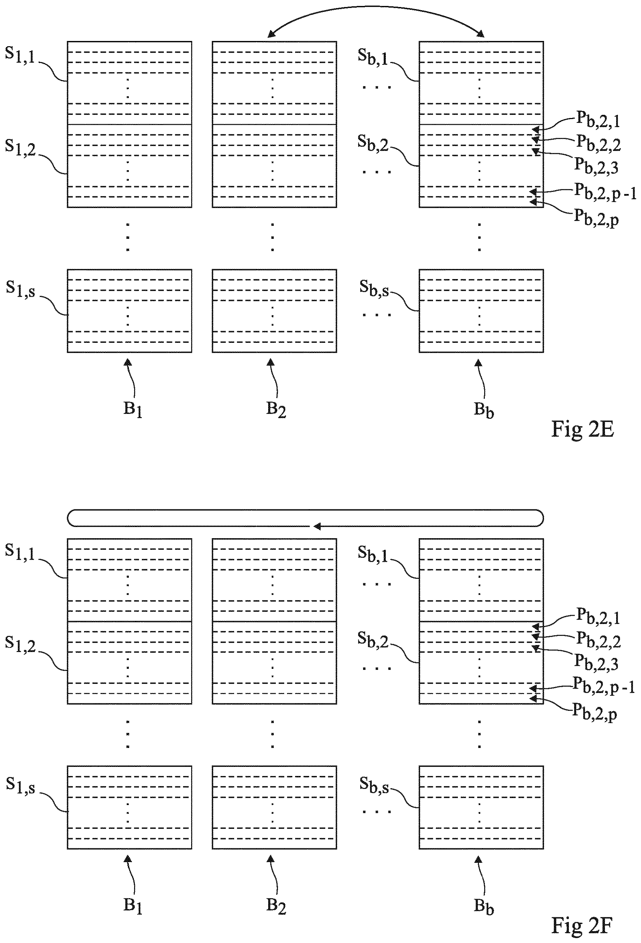

La figure 2E illustre schématiquement un cinquième exemple de procédé de gestion ou d'équilibrage d'usure qui peut être mis en oeuvre dans la mémoire 100 de la figure 1.

Dans cet exemple, après un certain nombre d'accès à un banc Bᵢ de la mémoire, le contenu de ce banc est permuté avec le contenu d'un autre banc de la mémoire, par exemple un banc ayant subi un nombre d'accès moins important, par exemple le banc de la mémoire ayant subi le nombre d'accès le plus faible.

A titre d'exemple, les accès à chaque banc de la mémoire peuvent être comptés, et, lorsque le nombre d'accès à un banc Bᵢ de la mémoire dépasse un seuil, une permutation du contenu de ce banc avec le contenu d'un autre banc de la mémoire peut être effectuée. A titre de variante, si le procédé de la figure 2C ou le procédé de la figure 2D est mis en oeuvre, une permutation du contenu d'un banc Bᵢ avec le contenu d'un autre banc peut être effectuée lorsque le banc Bᵢ a subi un certain nombre de permutations internes de segments (figure 2C) ou de rotations circulaires internes (figure 2D), par exemple égal au nombre de segments du banc.

La figure 2F illustre schématiquement un sixième exemple de procédé de gestion ou d'équilibrage d'usure qui peut être mis en oeuvre dans la mémoire 100 de la figure 1.

Dans cet exemple, après un certain nombre d'accès à la mémoire, une rotation circulaire interne des données de la mémoire est mise en oeuvre, c'est-à-dire que les bancs Bᵢ subissent une rotation circulaire à l'intérieur de la mémoire. A titre d'exemple, le contenu du premier banc B₁ est transféré dans le deuxième banc B₂, le contenu du deuxième banc B₂ est transféré dans le troisième banc B₃, et ainsi de suite jusqu'au dernier banc B_{b} dont le contenu est transféré dans le premier banc B₁.

A titre d'exemple, les accès à la mémoire peuvent être comptés, et, lorsque le nombre d'accès à la mémoire dépasse un seuil, la mémoire peut subir une rotation circulaire interne. A titre de variante, si le procédé de la figure 2C ou le procédé de la figure 2D est mis en oeuvre, une rotation circulaire interne de la mémoire peut être effectuée lorsqu'un même banc Bᵢ de la mémoire a subi un certain nombre de permutations internes de segments (figure 2C) ou de rotations circulaires internes (figure 2D), par exemple égal au nombre de segments du banc.

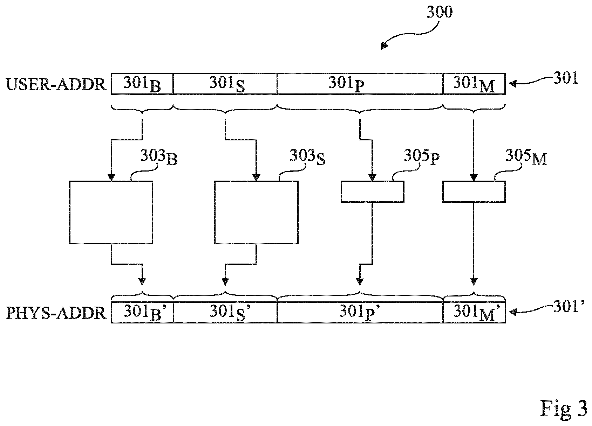

La figure 3 représente de façon schématique un exemple de réalisation d'un dispositif 300 permettant, lorsqu'un procédé de gestion d'usure du type décrit en relation avec les figures 2A à 2F est mis en oeuvre dans la mémoire 100 de la figure 1, de convertir des adresses logiques ou adresses utilisateur, qui sont les adresses utilisées par l'utilisateur pour accéder à des données dans la mémoire, en adresses dites physiques, qui sont les adresses où sont effectivement physiquement mémorisées les données dans la mémoire. Le dispositif 300 permet notamment, lorsqu'un utilisateur accède à la mémoire par son intermédiaire, de rendre transparents pour l'utilisateur les déplacements de données internes à la mémoire qui résultent du procédé d'équilibrage d'usure.

Dans l'exemple de la figure 3, on considère, à titre d'exemple illustratif non limitatif, le cas où le procédé d'équilibrage d'usure met en oeuvre les mécanismes des figures 2A, 2B, 2C et 2E.

Le dispositif 300 est adapté à recevoir une adresse utilisateur 301 (USER-ADDR) pointant sur un mot de la mémoire 100 visé par l'utilisateur, et à fournir une adresse physique 301' (PHYS-ADDR), correspondant à l'adresse réelle à laquelle le contenu du mot visé est effectivement mémorisé.

L'adresse utilisateur 301 comprend un premier sous-ensemble de bits 301_{B} définissant l'adresse du banc dans lequel, pour l'utilisateur, le contenu visé est supposé se trouver, c'est-à-dire l'adresse du banc dans lequel le contenu visé se trouverait effectivement si le procédé d'équilibrage d'usure n'était pas mis en oeuvre. L'adresse utilisateur 301 comprend en outre un deuxième sous-ensemble de bits 301_{S} définissant, à l'intérieur d'un banc, l'adresse du segment dans lequel, pour l'utilisateur, le contenu visé est supposé se trouver, un troisième sous-ensemble de bits 301p définissant, à l'intérieur d'un segment, l'adresse de la page dans laquelle, pour l'utilisateur, le contenu visé est supposé se trouver, et un quatrième sous-ensemble de bits 301_{M} définissant, à l'intérieur d'une page, l'adresse du mot dans lequel, pour l'utilisateur, le contenu visé est supposé se trouver.

L'adresse physique 301' comprend un premier sous-ensemble de bits 301_{B}' définissant l'adresse du banc dans lequel se trouve effectivement le contenu du mot visé par l'utilisateur. L'adresse physique 301' comprend en outre un deuxième sous-ensemble de bits 301_{S}' définissant, à l'intérieur du banc, l'adresse du segment dans lequel se trouve effectivement le contenu recherché, un troisième sous-ensemble de bits 301p' définissant, à l'intérieur du segment, l'adresse de la page dans laquelle se trouve effectivement le contenu recherché, et un quatrième sous-ensemble de bits 301_{M}' définissant, à l'intérieur de la page, l'adresse du mot dans lequel se trouve effectivement le contenu recherché.

Le dispositif 300 comprend un premier élément de conversion 303g, adapté à convertir l'adresse utilisateur de banc 301_{B} en l'adresse physique de banc 301g'. Dans cet exemple, l'élément de conversion 303_{B} comprend une table de traduction d'adresses de banc comportant b entrées de log2(b) bits chacune, b étant le nombre de bancs de la mémoire. A chaque permutation de bancs lors de la mise en oeuvre du procédé d'équilibrage d'usure de la figure 2E, les nouvelles adresses physiques 301_{B}' des contenus permutés sont mises à jour dans la table.

Le dispositif 300 comprend en outre un deuxième élément de conversion 303g, adapté à convertir l'adresse utilisateur de segment 301_{S} en l'adresse physique de segment 301_{S}'. Dans cet exemple, l'élément de conversion 303_{S} comprend, pour chaque banc de la mémoire, une table de traduction d'adresses de segment comportant s entrées de log2(s) bits chacune, s étant le nombre de segments du banc. A chaque permutation de segments lors de la mise en oeuvre du procédé d'équilibrage d'usure de la figure 2C, les nouvelles adresses physiques 301g' des contenus permutés sont mises à jour dans la table correspondante.

Le dispositif 300 comprend en outre un troisième élément de conversion 305p, adapté à convertir l'adresse utilisateur de page 301p en l'adresse physique de page 301p'. Dans cet exemple, l'élément de conversion 305p comprend, pour chaque segment de la mémoire, un registre de suivi de décalages, contenant le nombre de rotations circulaires internes subies par le segment lors de la mise en oeuvre du procédé d'équilibrage d'usure de la figure 2B. Pour déterminer l'adresse physique 301p' de la page recherchée, le dispositif 300 peut ajouter à l'adresse utilisateur de page 301p la valeur contenue dans le registre de suivi de décalages du segment, module p, où p est le nombre de pages du segment.

Le dispositif 300 comprend en outre un quatrième élément de conversion 305_{M}, adapté à convertir l'adresse utilisateur de mot 301_{M} en l'adresse physique de mot 301_{M}'. Dans cet exemple, l'élément de conversion 305p comprend, pour chaque page de la mémoire, un registre de suivi de décalages, contenant le nombre de rotations circulaires internes subies par la page lors de la mise en oeuvre du procédé d'équilibrage d'usure de la figure 2A. Pour déterminer l'adresse physique 301_{M}' du mot recherché, le dispositif 300 peut ajouter à l'adresse utilisateur de mot 301_{M} la valeur contenue dans le registre de suivi de décalages la page, module m, où m est le nombre de mots de la page.

Les modes de réalisation décrits dans la présente demande ne se limitent pas à l'exemple particulier de dispositif de conversion d'adresses de la figure 3. Plus généralement, quels que soient les déplacements de contenus mis en oeuvre dans une mémoire pour équilibrer son usure, on peut prévoir un dispositif de conversion d'adresses permettant de convertir des adresses utilisateurs en adresses physiques, par exemple en utilisant des tables de traduction d'adresses et/ou des registres de suivi de décalages.

Il serait souhaitable de pouvoir mettre en oeuvre un procédé de gestion ou d'équilibrage d'usure impliquant des déplacements de contenus à l'intérieur de la mémoire, par exemple des procédés du type décrit en relation avec les figures 2A à 2F, sans que cela n'entraine d'interruption de service prolongée pour l'utilisateur de la mémoire, c'est-à-dire sans que l'accès à la mémoire ne soit bloqué de façon ininterrompue pour l'utilisateur pendant les phases de déplacement de données du procédé de gestion d'usure.

En effet, à titre d'exemple illustratif, la permutation du contenu de deux segments de la mémoire 100 de la figure 1 requiert 2*p opérations de lecture et 2*p opérations d'écriture, où p est le nombre de pages dans un segment. Si on considère l'exemple numérique susmentionné d'une mémoire comportant 4096 pages par segment, et si on considère une mémoire présentant un temps d'accès en lecture de page de 50 ns et un temps d'accès en écriture de 50 ns, le temps requis pour permuter le contenu de deux segments peut être de l'ordre de 2*2*4096*50 ns = 819 µs. Dans de nombreuses applications, bloquer l'accès à la mémoire sans interruption pendant une telle durée pose problème.

Selon un aspect des modes de réalisation décrits, on prévoit un système comportant une mémoire de plusieurs pages, et un circuit de contrôle adapté à mettre en oeuvre un procédé de gestion d'usure comportant des permutations de contenus à l'intérieur de la mémoire, par exemple un procédé du type décrit en relation avec les figures 2A à 2F, le circuit de contrôle étant adapté à intercaler, entre des opérations consécutives de lecture ou d'écriture de page du procédé d'équilibrage d'usure, un ou plusieurs accès utilisateur à des pages de la mémoire.

Par opérations consécutives de lecture ou d'écriture du procédé d'équilibrage d'usure, on entend ici deux étapes de lecture ou d'écriture de page du procédé d'équilibrage d'usure non séparées par une autre étape de lecture ou d'écriture de page du procédé d'équilibrage d'usure, et par accès utilisateur, on entend une opération de lecture ou d'écriture d'une page de la mémoire pour toute utilisation autre que la mise en oeuvre du procédé d'équilibrage d'usure.

En d'autres termes, dans le système proposé, les opérations de lecture et d'écriture de page du procédé d'équilibrage d'usure de la mémoire sont étalées dans le temps, et séparées les unes des autres par des intervalles de temps au cours desquels des accès utilisateur peuvent avoir lieu. Un tel système permet à l'utilisateur de pouvoir continuer à accéder à la mémoire pendant les phases de déplacement de données du procédé d'équilibrage. Ceci permet de rendre le procédé d'équilibrage d'usure pratiquement transparent pour l'utilisateur du point de vue des temps d'accès à la mémoire. En effet, dans un tel système, une requête utilisateur d'accès à la mémoire sera retardée au plus d'un cycle mémoire du fait de la mise en oeuvre du procédé d'équilibrage d'usure.

Les opérations de lecture ou d'écriture de page du procédé d'équilibrage d'usure et les accès utilisateurs peuvent être effectués successivement par le circuit de contrôle via un même port d'accès de la mémoire. Par port d'accès, on désigne ici un ensemble de bornes d'entrée et/ou sortie adapté à recevoir un signal d'adresse, à recevoir un signal de donnée d'entrée, et à fournir un signal de donnée de sortie. Un port d'accès peut notamment comporter une entrée d'adresse sur plusieurs bits, adaptée à recevoir un signal d'adresse d'une page de la mémoire, une entrée de donnée sur plusieurs bits, adaptée à recevoir un signal de donnée à écrire dans une page de la mémoire, et une sortie de donnée sur plusieurs bits, adaptée à fournir un signal de donnée lue dans une page de la mémoire, l'entrée de donnée et la sortie de donnée pouvant éventuellement être confondues.

Le nombre d'accès utilisateur entre deux opérations consécutives de lecture ou d'écriture du procédé d'équilibrage d'usure et/ou l'intervalle de temps séparant deux opérations consécutives de lecture ou d'écriture du procédé d'équilibrage d'usure peuvent être constants ou non. A titre d'exemple non limitatif, l'intervalle de temps séparant deux opérations consécutives de lecture ou d'écriture du procédé d'équilibrage d'usure est constant. Le nombre d'accès en lecture de page ou en écriture de page qui peut être effectué dans cet intervalle de temps est par exemple compris entre quelques dizaines et quelques milliers, par exemple entre cinquante et dix mille.

On notera que dans les mémoires DRAM, pour éviter des pertes d'information, il est nécessaire de périodiquement rafraîchir, c'est-à-dire lire puis réécrire à l'identique, chaque page de la mémoire. Pour cela, un système utilisant une mémoire DRAM comprend généralement un contrôleur DRAM, c'est-à-dire un circuit faisant interface entre la mémoire DRAM et un circuit utilisateur, par exemple un processeur. Le contrôleur DRAM insère périodiquement, entre des accès utilisateur, des cycles de rafraîchissement au cours desquels des pages de la mémoire peuvent être lues et réécrites à l'identique. Dans les mémoires résistives, le rafraîchissement des données n'est pas nécessaire. Dans un système comportant une mémoire résistive, on peut par exemple prévoir de séparer deux opérations consécutives de lecture ou d'écriture de page du procédé d'équilibrage d'usure par un intervalle de temps identique ou du même ordre de grandeur que l'intervalle de temps séparant deux cycles de rafraîchissement consécutifs dans un système comportant une mémoire DRAM.

A titre d'exemple, les circuits mettant en oeuvre le procédé d'équilibrage d'usure peuvent être intégrés dans la puce comportant la mémoire résistive. Dans ce cas, on peut aisément, dans un système standard à mémoire DRAM, remplacer la mémoire DRAM par la puce comportant la mémoire résistive, et conserver un contrôleur DRAM standard pour faire interface entre la puce mémoire et le circuit utilisateur. Les cycles de rafraîchissement périodiquement insérés par le contrôleur DRAM parmi les accès utilisateurs sont alors utilisés par la puce mémoire comme cycles d'équilibrage d'usure, pour mettre en oeuvre une étape de lecture ou d'écriture du procédé d'équilibrage d'usure.

Alternativement, les circuits mettant en oeuvre le procédé d'équilibrage d'usure peuvent être intégrés dans le contrôleur faisant interface entre la puce mémoire et le circuit utilisateur, ce qui permet de rendre le système compatible avec des puces mémoires dans lesquelles aucun circuit d'équilibrage d'usure n'est prévu.

En d'autres termes, le circuit de contrôle peut comprendre au moins deux sous-circuits, un premier sous-circuit adapté à mettre en oeuvre le procédé d'équilibrage d'usure proprement dit, et un deuxième sous-circuit adapté à gérer les accès utilisateur et l'alternance des accès utilisateur et des cycles d'équilibrage d'usure. Le premier sous-circuit peut être soit intégré dans la puce mémoire elle-même soit être à l'extérieur de la puce mémoire, par exemple dans une puce intégrant les premier et deuxième sous-circuits.

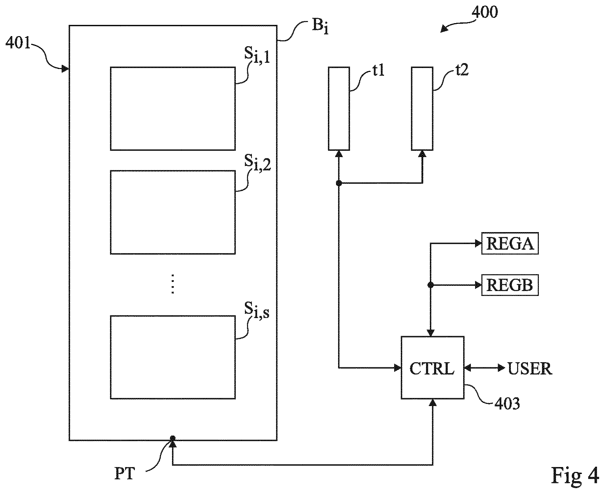

La figure 4 représente de façon schématique et partielle un exemple d'un mode de réalisation d'un système 400 comportant une mémoire 401 et des moyens de mise en oeuvre d'un procédé de gestion de l'usure de cette mémoire.

La mémoire 401 présente par exemple une organisation logique identique ou similaire à celle de la mémoire 100 de la figure 1. Sur la figure 4, seul un banc Bᵢ de la mémoire 401 a été représenté. La mémoire 401 comporte au moins un port PT permettant, à chaque cycle mémoire (la mémoire 401 peut être cadencée par une horloge non représentée), de lire ou d'écrire une page de la mémoire. A titre d'exemple, chaque banc Bᵢ de la mémoire 401 comporte un port d'accès PT permettant, à chaque cycle mémoire, d'accéder à une page du banc.

Le système 400 comprend un circuit de contrôle 403 (CTRL), comportant par exemple un circuit câblé spécifique, par exemple une machine à état fini, ou un microcontrôleur. Le circuit 403 est adapté à recevoir des requêtes d'accès à la mémoire provenant d'un circuit utilisateur (USER), et à traiter ces requêtes, en accédant aux bancs Bᵢ de la mémoire via les ports d'accès PT. Le circuit 403 est de plus adapté à mettre en oeuvre un procédé de gestion ou d'équilibrage de l'usure de la mémoire 401 comportant des déplacements de données à l'intérieur d'un même segment ou entre des segments distincts d'un même banc ou de bancs distincts, par exemple un procédé type décrit en relation avec les figures 2A à 2F. Pour effectuer les déplacements de données du procédé d'équilibrage d'usure, le circuit 403 accède à la mémoire via les mêmes ports d'accès PT que ceux utilisés pour effectuer les accès utilisateur. Pour effectuer les déplacements de données du procédé de gestion d'usure, le circuit 403 insère, entre des accès utilisateur, par exemple périodiquement, des cycles d'équilibrage d'usure. Au cours de chaque cycle d'équilibrage d'usure, une page de la mémoire peut être lue ou écrite pour la mise en oeuvre du procédé d'équilibrage d'usure. Chaque cycle d'équilibrage d'usure est précédé et suivi d'un intervalle de temps au cours duquel des accès utilisateur à des pages de la mémoire peuvent être effectués.

Pour que les déplacements de données mis en oeuvre par le procédé d'équilibrage d'usure soient, du point de vue de l'adressage, transparents pour l'utilisateur, le système 400 peut comporter un dispositif de conversion d'adresse (non représenté sur la figure 4) du type décrit en relation avec la figure 3. Le dispositif de conversion d'adresse peut être tenu à jour par le circuit 403 au fur et à mesure que les déplacements de données sont effectués.

Dans l'exemple de la figure 4, le système 400 comprend deux tables t1 et t2 comportant chacune un nombre d'entrées ou valeurs de 2 bits égal au nombre de pages P_{i,j,k} que contient un segment S_{i,j}, soit p entrées de 2 bits dans cet exemple. De plus, le système 400 comprend deux registres REGA et REGB adaptés à mémoriser chacun le contenu d'une page P_{i,j,k} de la mémoire. Le circuit de contrôle 403 est adapté à lire et écrire dans les tables t1 et t2 et les registres REGA et REGB. A titre d'exemple non limitatif, les tables t1 et t2 et les registres REGA et REGB peuvent être réalisés dans une mémoire de technologie différente de celle de la mémoire 401, par exemple dans une mémoire présentant des temps d'accès plus courts que la mémoire 401, par exemple une mémoire SRAM (de l'anglais "Static Random Access Memory" - mémoire statique à accès aléatoire).

Lorsqu'un déplacement de données interne à un segment est effectué par le circuit 403, le circuit 403 peut affecter la table t1 au segment Sᵢ,ⱼ concerné, et tenir à jour la table t1. Pour chaque page du segment S_{i,j}, la table t1 indique l'état de la page parmi les possibilités suivantes :
le contenu de la page n'a pas été transféré ; ou le contenu de la page est dans le registre REGA (en cours de transfert) ; ou
le contenu de la page est dans le registre REGB (en cours de transfert) ; ou
le contenu de la page a été transféré dans une autre page.

A titre d'exemple, pour réaliser une rotation circulaire interne d'un segment S_{i,j} lors de la mise en oeuvre du procédé de la figure 2B, le circuit 403 peut par exemple, à chaque cycle d'équilibrage d'usure, mettre en oeuvre l'une des étapes du procédé suivant :
lire le contenu de la première page P_{i,j,1} du segment S_{i,j}, écrire ce contenu dans le registre REGA, et mettre à jour la table t1 pour cette page ;
lire le contenu de la deuxième page P_{i,j,2} du segment S_{i,j}, écrire ce contenu dans le registre REGB, et mettre à jour la table t1 pour cette page ;
écrire le contenu du registre REGA dans la deuxième page P_{i,j,2} du segment et mettre à jour la table t1 pour la page P_{i,j, 1} ;
lire le contenu de la troisième page P_{i,j,3} du segment S_{i,j}, écrire ce contenu dans le registre REGA, et mettre à jour la table t1 pour cette page ;
écrire le contenu du registre REGB dans la troisième page P_{i,j,3} du segment et mettre à jour la table t1 pour la page P_{i,j, 2} ;
et ainsi de suite jusqu'au transfert du contenu de la dernière page P_{i,j,p} du segment dans la première page P_{i,j,1}.

Plus généralement, des procédés du même type peuvent être mis en oeuvre par le circuit 403 pour déplacer des données soit à l'intérieur d'un même segment S_{i,j} soit entre des segments distincts de la mémoire, quels que soient les déplacements envisagés (rotation circulaire des mots de la page - figure 2A, rotation circulaire des pages du segment - figure 2B, permutation de segments à l'intérieur d'un banc - figure 2C, rotation circulaire de segments à l'intérieur d'un banc - figure 2D, permutation de bancs - figure 2E, rotation circulaire des bancs de la mémoire - figure 2F, ou autre). Lorsqu'un déplacement de contenus de pages entre des premier et deuxième segments distincts est effectué, le circuit 403 peut affecter la table t1 au premier segment et affecter la table t2 au deuxième segment, et tenir à jour les tables t1 et t2. Les tables t1 et t2 indiquent l'état (transférée, pas transférée, ou en cours de transfert) de chacune des pages de chacun des deux segments concernés. Les déplacements comportant plusieurs permutations de contenus de segments à l'intérieur d'un même banc peuvent être effectués séquentiellement. Optionnellement, par exemple pour effectuer une rotation circulaire de segments à l'intérieur d'un banc, le système peut comprendre une mémoire tampon supplémentaire de la taille d'un segment, par exemple réalisée en mémoire SRAM. De plus, le système peut optionnellement comprendre une mémoire supplémentaire de la taille d'un banc, par exemple une mémoire résistive, par exemple pour effectuer une rotation circulaire des bancs de la mémoire.

Si un accès utilisateur survient dans un segment S_{i,j} alors qu'un déplacement de données en cours affecte ce segment, le circuit 403 peut consulter la table t1 ou t2 affectée au segment pour savoir :
si le contenu de la page visée a déjà été transféré, auquel cas la donnée est lue ou écrite à sa nouvelle adresse dans la mémoire ;
si le contenu de la page visée est dans le registre REGA ou dans le registre REGB, auquel cas la donnée est lue ou écrite dans le registre REGA ou REGB ; ou
si le contenu de la page visée n'a pas été transféré, auquel cas la donnée est lue ou écrite à son adresse d'origine dans le segment S_{i,j}.

Le système 400 de la figure 4 permet de mettre en oeuvre un procédé de gestion ou d'équilibrage d'usure impliquant des déplacements de contenus à l'intérieur de la mémoire, ces déplacements étant, pour l'utilisateur, transparents du point de vue de l'adressage des données, et pratiquement transparents du point de vue du temps d'accès au contenu de la mémoire.

Dans l'exemple de réalisation de la figure 4, si les mémoires utilisées pour réaliser les tables t1 et t2, les registres REGA et REGB, ainsi que d'autres éléments de stockage de données utiles à la mise en oeuvre du procédé d'équilibrage d'usure (compteurs d'accès mémoire, tables de traductions d'adresses utilisateur en adresses physiques, registres de suivi de déplacements, etc.) sont des mémoires volatiles, par exemple réalisées en technologie SRAM, on peut prévoir, à la mise hors tension du système, de transférer les données contenues dans ces divers éléments de stockage dans une mémoire non volatile pour ne pas perdre ces données.

Des modes de réalisation particuliers ont été décrits. Diverses variantes et modifications apparaîtront à l'homme de l'art.

En particulier, les modes de réalisation décrits ne se limitent pas aux exemples susmentionnés d'organisation logique des cellules élémentaires dans une mémoire ni aux exemples susmentionnés de déplacements de données dans la mémoire pour équilibrer son usure.

Plus généralement, quelle que soit l'organisation logique interne de la mémoire, et quels que soient les déplacements de données envisagés pour équilibrer l'usure de la mémoire, l'homme du métier saura, à partir de l'enseignement décrit ci-dessus, réaliser un système dans lequel des déplacements de données du procédé d'équilibrage d'usure sont effectués pendant des cycles de gestion d'usure insérés entre des accès utilisateur.

De plus, les modes de réalisation décrits ne se limitent pas à l'exemple particulier décrits en relation avec la figure 4 de moyens permettant d'effectuer les déplacements de données du procédé d'équilibrage d'usure et de gérer les accès utilisateur notamment lorsque des données sont en cours de déplacement dans le cadre du procédé d'équilibrage d'usure. On notera en particulier que lorsque le procédé d'équilibrage d'usure comprend des rotations circulaires de données à l'intérieur d'une page, par exemple du type décrit en relation avec la figure 2A, le système peut comprendre un ou plusieurs circuits spécifiques adaptés à effectuer un décalage circulaire du contenu d'une page pendant un cycle de lecture ou d'écriture dans la mémoire principale.

Par ailleurs, on a décrit ci-dessus des modes de réalisation dans lesquels un procédé d'équilibrage d'usure comportant des déplacements de données à l'intérieur de la mémoire est mis en oeuvre, chaque étape de lecture ou d'écriture du procédé d'équilibrage d'usure étant suivie d'un ou plusieurs accès utilisateur. Les modes de réalisation décrits visent cependant aussi des procédés de gestion d'usure ne comportant pas de déplacements de données à l'intérieur de la mémoire, c'est-à-dire ne conduisant pas à modifier l'emplacement physique des données dans la mémoire. A titre d'exemple, les modes de réalisation décrits sont compatibles avec un procédé de gestion d'usure comportant des opérations de rafraîchissement de données contenues dans des pages de la mémoire. Une telle opération de rafraîchissement comprend par exemple une étape de lecture des données contenues dans une page de la mémoire, suivie d'une étape de réécriture des données lues à la même adresse dans la mémoire. Dans ce cas, on prévoit, similairement à ce qui a été décrit ci-dessus, d'intercaler un ou plusieurs accès utilisateur entre l'étape de lecture et l'étape d'écriture d'un même cycle de rafraîchissement. Plus généralement, les modes de réalisation décrits sont compatibles avec tous types de procédés de gestion d'usure comportant des accès en lecture et/ou en écriture aux données stockées dans la mémoire.

De plus, on a décrit ci-dessus des exemples de réalisation dans lesquels, pour estimer l'usure d'une portion de mémoire et décider en conséquence de mettre en oeuvre ou non un procédé de gestion d'usure ciblant cette portion, on compte les accès en lecture et/ou en écriture à la portion de mémoire. Les modes de réalisation décrits ne se limitent toutefois pas à ce cas particulier. Plus généralement, toute autre méthode permettant de mesurer ou estimer l'usure d'une portion de mémoire résistive peut être utilisée pour décider la planification des procédés de gestion d'usure.

Ces méthodes de mesure d'usure peuvent par exemple être mises en oeuvre par le circuit de contrôle 403 de la figure 4, ou par tout autre circuit adapté. Les différentes étapes de lecture et/ou d'écriture des procédés de mesure d'usure peuvent être mises en oeuvre lors des cycles dédiés à la gestion d'usure, et être ainsi séparées deux à deux par des accès utilisateur.

De plus, pour prolonger davantage sa durée de vie, la mémoire peut comporter une réserve de cellules redondantes prévue à la conception du circuit, c'est-à-dire des cellules inutilisées au début du cycle de vie de la mémoire et destinées à remplacer des cellules ayant atteint un seuil critique d'usure après un certain temps d'utilisation. Les procédés de gestion d'usure peuvent, lorsqu'un mot ou une page atteint un seuil d'usure critique, remplacer le mot ou la page usée par un mot ou une page "neuve" de la réserve de cellules redondantes.

A titre d'exemple, l'usure d'une page d'une mémoire résistive peut être mesurée par un procédé du type décrit dans la demande de brevet US2013/0235649. Un tel procédé de mesure d'usure consiste substantiellement en : lire la page dont on souhaite mesurer l'usure et stocker la donnée lue dans un élément de stockage intermédiaire ; écrire à l'état fortement résistif (valeur binaire '0') tous les bits de la page ; appliquer une tension de polarisation et mesurer la somme des courants circulant dans les cellules élémentaires de la page ; puis réécrire dans la page la donnée mémorisée dans l'élément de stockage intermédiaire. La somme ou valeur moyenne des courants circulant dans les cellules élémentaires de la page constitue alors un indicateur d'usure de la page. En effet, plus le courant est élevé, plus la résistance des cellules à l'état fortement résistif est faible, et plus la page est considérée usée. Cette mesure peut être comparée à celle d'autres pages pour la planification d'un procédé de gestion d'usure du type décrit ci-dessus.

A titre de variante, le procédé de mesure d'usure peut comporter non seulement une première mesure de courant après que les cellules de la page aient été programmées à l'état fortement résistif (valeur binaire '0'), mais aussi une deuxième mesure de courant après que les cellules de la page aient été programmées à l'état faiblement résistif (valeur binaire '1'). Dans ce cas, la différence entre les deux valeurs de courant lues peut constituer un indicateur d'usure de la page. Un avantage est alors que le critère d'appréciation de l'usure est représentatif de la différence de résistivité entre l'état fortement résistif et l'état faiblement résistif des cellules de la page, qui est la grandeur permettant effectivement aux cellules de mémoriser des données.

A titre de variante, on peut prévoir un procédé de mesure d'usure basé sur les principes suivants :
le contenu courant de la page dont on souhaite déterminer l'usure sert de base à la mesure d'usure, de façon à éviter l'étape d'écriture de tous les bits de la page à une même valeur (contribuant à l'usure du mot) ; et
l'usure des différents bits de la page est appréciée individuellement, la page étant considérée usée dès lors que l'un de ses bits a atteint un seuil d'usure critique (ce qui permet de détecter des cas d'usure dans lesquels un seul bit de la page, ou un faible nombre de bits de la page, sont usés, cas qui pourraient ne pas être détectés par les méthodes précédentes de mesure du courant moyen circulant dans la page).

Un tel procédé peut par exemple comporter les étapes successives suivantes :
lire une première fois le contenu de la page dont on souhaite mesurer l'usure avec un seuil de courant standard de discrimination entre les valeurs binaires '0' et '1' (c'est-à-dire un seuil égal au seuil de discrimination utilisé, en fonctionnement normal, lors des accès utilisateur en lecture), et enregistrer la valeur lue dans un élément de stockage intermédiaire ;
lire une deuxième fois le contenu de la page avec un seuil de courant de discrimination entre les valeurs binaires '0' et '1' abaissé par rapport au seuil standard, et comparer la valeur lue avec la valeur mémorisée dans l'élément de stockage intermédiaire en effectuant un OU EXCLUSIF bit à bit entre les deux valeurs ; et
si au moins l'un des bits de sortie du OU EXCLUSIF est à la valeur binaire '1', en déduire que le bit correspondant de la page est usé.

On notera que le niveau d'usure mesuré dépend alors du décalage entre le seuil standard de discrimination entre les valeurs binaires '0' et '1', et le seuil de discrimination abaissé utilisé lors de la deuxième lecture. Le cas échéant, un nombre de lectures supérieur à deux peut être réalisé en utilisant des seuils de discrimination distincts lors des différentes lectures.

A titre d'exemple, pour analyser l'usure d'un segment de la mémoire, on peut prévoir un procédé comportant une étape d'initialisation, par exemple à la valeur 0, d'un compteur de pages usées du segment, puis, pour chaque page du segment, les étapes suivantes :
a) lire une première fois le contenu de la page avec un premier seuil de discrimination entre les valeurs binaires '0' et '1' égal au seuil standard de discrimination, et mémoriser la valeur lue dans un élément de stockage intermédiaire ;
b) lire une deuxième fois le contenu de la page avec un deuxième seuil de discrimination entre les valeurs binaires '0' et '1' abaissé par rapport au premier seuil, puis comparer la valeur lue avec la valeur mémorisée dans l'élément de stockage intermédiaire en effectuant un OU EXCLUSIF entre les deux valeurs ;
c) si au moins l'un des bits du résultat du OU EXCLUSIF est à la valeur binaire '1', en déduire que la page présente un niveau d'usure avancé ;
d) lire une troisième fois le contenu de la page avec un troisième seuil de discrimination entre les valeurs binaires '0' et '1' rehaussé par rapport au premier seuil, puis comparer la valeur lue avec la valeur mémorisée dans l'élément de stockage intermédiaire en effectuant un OU EXCLUSIF entre les deux valeurs ;
e) si au moins l'un des bits du résultat du OU EXCLUSIF est à la valeur binaire '1', en déduire que la page présente un niveau d'usure avancé ;
f) si la page est jugée comme présentant un niveau d'usure avancé suite à la deuxième ou à la troisième lecture, et si des pages redondantes sont disponibles dans la mémoire, remplacer la page par une page redondante, c'est-à-dire réaffecter à une page redondante l'adresse utilisateur correspondant à la page usée ;
g) si la page est jugée comme présentant un niveau d'usure avancé suite à la deuxième ou à la troisième lecture, et si aucune page redondante n'est disponible, déclencher la machine de permutation de segment afin de permuter le contenu du segment avec celui d'un segment moins usé, et cesser l'analyse d'usure du segment ;
h) si la page n'est pas jugée comme présentant un niveau d'usure avancé, lire une quatrième fois le contenu de la page avec un quatrième seuil de discrimination entre les valeurs binaires '0' et '1' abaissé par rapport au deuxième seuil, puis comparer la valeur lue avec la valeur mémorisée dans l'élément de stockage intermédiaire en effectuant un OU EXCLUSIF entre les deux valeurs ;
i) si au moins l'un des bits du résultat du OU EXCLUSIF est à la valeur binaire '1', en déduire que la page présente un niveau d'usure intermédiaire inférieur au niveau d'usure avancé susmentionné ;
j) lire alors une cinquième fois le contenu de la page avec un cinquième seuil de discrimination entre les valeurs binaires '0' et '1' rehaussé par rapport au troisième seuil, puis comparer la valeur lue avec la valeur mémorisée dans l'élément de stockage intermédiaire en effectuant un OU EXCLUSIF entre les deux valeurs ;
k) si au moins l'un des bits du résultat du OU EXCLUSIF est à la valeur binaire '1', en déduire que la page présente un niveau d'usure intermédiaire inférieur au niveau d'usure avancé ; et
l) si la page est jugée comme présentant un niveau d'usure intermédiaire suite à la quatrième ou à la cinquième lecture, incrémenter le compteur de pages usées du segment.

Lorsque toutes les pages du segment ont été ainsi testées, la valeur du compteur de pages usées du segment est comparée à une valeur de nombre de pages usées préalablement déterminée et mémorisée pour ce segment. Si la nouvelle valeur est supérieure à l'ancienne valeur, la nouvelle valeur est mémorisée et vient remplacer l'ancienne valeur. Si la nouvelle valeur de nombre de pages usées est supérieure à un seuil, un mécanisme de permutation du contenu du segment avec le contenu d'un autre segment moins usé peut être déclenché ou programmé. Sinon, un mécanisme de permutation des contenus des pages à l'intérieur du segment peut être déclenché ou programmé.

Si une lecture utilisateur survient dans le segment en cours d'analyse, cette lecture peut être faite directement dans la mémoire, étant donné que le contenu du segment n'est pas affecté par le procédé d'analyse d'usure.

En revanche, si une écriture utilisateur survient dans une page en cours d'analyse, cette écriture est effectuée à la fois dans la mémoire et dans l'élément de stockage intermédiaire mémorisant le contenu de la page. Ainsi, les éléments de stockage intermédiaire utilisés pour la mise en oeuvre du procédé d'analyse d'usure de la mémoire peuvent notamment comporter un registre d'adresse mémorisant l'adresse de la page en cours d'analyse, de façon à pouvoir comparer cette adresse à l'adresse visée par l'utilisateur lors d'un accès utilisateur en écriture.

On notera que les étapes d), e), j) et k) sont facultatives. En d'autres termes, on peut se dispenser de lire les données avec des seuils de discrimination rehaussés par rapport au seuil standard. En effet, généralement, l'usure d'une page se traduit essentiellement par une diminution de la résistance de la cellule lorsque la cellule est programmée à l'état fortement résistif. Ainsi, la seule lecture avec un seuil de discrimination abaissé par rapport au seuil standard peut être suffisante pour détecter des cellules usées.

Par ailleurs, dans l'exemple de la figure 4, on a décrit un système comportant des tables t1, t2 comportant chacune p mots de 2 bits, indiquant si une page d'un segment en cours de transfert a ou non été transférée. A titre de variante, si le transfert des pages est effectué dans l'ordre croissant ou décroissant des adresses du segment, les tables t1, t2 peuvent être omises, et un compteur peut être incrémenté à chaque transfert de page. Lors d'un accès utilisateur, l'adresse visée par l'utilisateur peut être comparée à la valeur du compteur, pour savoir si la page correspondante a ou non été transférée.

De plus, les modes de réalisation décrits sont compatibles avec des procédés de gestion d'usure visant à "réparer" des cellules usées, ou à écrire de façon robuste des données dans des cellules usées. Un tel procédé peut par exemple consister à écrire et effacer alternativement une pluralité de fois des cellules défectueuses. A titre de variante ou à titre complémentaire, une cellule défectueuse peut être au moins partiellement régénérée en effectuant une réinitialisation de la cellule, c'est-à-dire en lui appliquant une tension de programmation de même polarité que la tension normalement utilisée pour écrire la cellule à l'état faiblement résistif, mais de valeur supérieure, et pendant une durée pouvant être supérieure à la durée normale d'écriture d'une cellule.

A titre d'exemple, lorsqu'un mot défectueux est identifié (par exemple par un procédé de mesure d'usure du type susmentionné) ou lorsqu'une écriture incorrecte d'un mot est détectée, un procédé comportant les étapes suivantes peut être mis en oeuvre.
a) Mémoriser le contenu du mot et, le cas échéant, son adresse, dans un élément de stockage intermédiaire.
b) Ecrire (c'est-à-dire programmer à l'état faiblement résistif) puis effacer (c'est-à-dire programmer à l'état fortement résistif) les bits défectueux (lors de cette étape, on peut prévoir de ne traiter que les bits défectueux, pour ne pas user inutilement les autres bits du mot).
c) Mesurer l'usure du mot, par exemple via un procédé de mesure d'usure du type susmentionné, ou vérifier si l'état des cellules identifiées comme défectueuses est redevenu correct.
d) Si les cellules identifiées sont toujours défectueuses, réitérer les étapes b), c) et d). Sinon, terminer le procédé de réparation.
e) Lorsque le nombre d'itérations des étapes b), c) et d) atteint un seuil et que des cellules sont toujours défectueuses, copier l'intégralité du segment contenant le mot dans un segment redondant, et faire correspondre l'adresse utilisateur pour ce segment à l'adresse physique du nouveau segment.
f) Réinitialiser les bits défectueux du segment défectueux en leur appliquant une tension de programmation de même polarité que la tension normalement utilisée pour écrire la cellule à l'état faiblement résistif, mais de valeur supérieure, et pendant une durée pouvant être supérieure à la durée normale d'écriture d'une cellule.
g) Lorsque tous les bits défectueux du segment ont été réinitialisés, rendre le segment disponible dans la liste des segments redondants, et terminer le procédé de réparation.

On notera que, dans le cas où les cellules défectueuses sont à l'état faiblement résistif, les opérations d'écriture et d'effacement de l'étape b) peuvent être interverties.

Un tel procédé de réparation peut par exemple être mis en oeuvre par le circuit de contrôle 403 de la figure 4, ou par tout autre circuit adapté. Les différentes étapes de lecture et/ou d'écriture du procédé de réparation peuvent être mises en oeuvre lors des cycles dédiés à la gestion d'usure, et être ainsi séparées deux à deux par des accès utilisateur.

Si un accès utilisateur visant un mot en cours de réparation survient, cet accès peut être effectué dans l'élément de stockage intermédiaire mémorisant le contenu du mot, ou, si le mot défectueux a été permuté avec un mot d'un segment redondant, dans le segment redondant devenu le nouveau segment physique pour la donnée visée.

L'étendue de la protection de la présente invention est définie par les revendications 1 à 16 annexées.

## Revendications

1. Système (400) comportant :
une mémoire résistive non volatile (100 ; 401) comprenant une pluralité de pages (P_{i,j,k}) ; et
un circuit de contrôle (403) adapté à effectuer des accès utilisateur à la mémoire et à mettre en oeuvre un procédé de gestion de l'usure de la mémoire,
**caractérisé en ce que** le circuit de contrôle (403) est configuré pour effectuer, entre des première et deuxième opérations consécutives de lecture ou d'écriture de page (P_{i,j,k}) du procédé de gestion d'usure, et entre la deuxième opération et une troisième opération consécutive de lecture ou d'écriture de page (P_{i,j,k}) du procédé de gestion d'usure, un ou plusieurs accès utilisateur à des pages (P_{i,j,k}) de la mémoire, aucune autre opération de lecture ou d'écriture de page du procédé de gestion d'usure n'étant effectuée entre les première et deuxième opérations et entre les deuxième et troisième opérations,
et **en ce que** le système comporte en outre des éléments (REGA, REGB) de stockage intermédiaire de données, le circuit de contrôle (403) étant configuré pour, lors de la mise en oeuvre du procédé de gestion d'usure, mémoriser temporairement dans lesdits éléments de stockage (REGA, REGB) des données de la mémoire, et, lorsqu'un accès utilisateur en lecture ou en écriture survient, vérifier si les données visées par l'utilisateur sont contenues dans lesdits éléments de stockage (REGA, REGB), et, si elles le sont, traiter l'accès utilisateur directement dans lesdits éléments de stockage (REGA, REGB).

2. Système (400) selon la revendication 1, comportant un compteur ou une table (t1, t2) permettant au circuit de contrôle (403) de savoir quelles adresses de la mémoire sont en cours de traitement par le procédé de gestion d'usure.

3. Système (400) selon la revendication 1 ou 2, dans lequel le procédé de gestion d'usure est un procédé d'équilibrage d'usure comportant des déplacements de données conduisant à modifier l'adresse physique des données à l'intérieur de la mémoire.

4. Système (400) selon la revendication 3, dans lequel lesdits éléments de stockage intermédiaire comportent des premier (REGA) et second (REGB) registres adaptés à mémoriser chacun le contenu d'une page (P_{i,j,k}) de la mémoire.

5. Système (400) selon la revendication 3 ou 4, dans lequel lesdits éléments de stockage intermédiaire (REGA, REGB) sont des éléments de mémoire volatile.

6. Système (400) selon l'une quelconque des revendications 1 à 5, dans lequel le circuit de contrôle (403) insère périodiquement, parmi des cycles mémoire réservés aux accès utilisateur, des cycles de gestion d'usure, une opération de lecture ou une opération d'écriture du procédé de gestion d'usure pouvant être effectuée à chaque cycle de gestion d'usure.

7. Système (400) selon l'une quelconque des revendications 1 à 6, dans lequel le circuit de contrôle (403) est adapté à effectuer lesdits accès utilisateur et lesdites opérations de lecture ou d'écriture de page (P_{i,j,k}) du procédé de gestion d'usure via un même port d'accès (PT) de la mémoire (401) .

8. Système (400) selon l'une quelconque des revendications 1 à 7, dans lequel le circuit de contrôle (403) est configuré de sorte que les opérations consécutives de lecture ou d'écriture du procédé de gestion d'usure sont séparées deux à deux par des intervalles de temps de même durée.

9. Système (400) selon la revendication 8, dans lequel, dans chacun desdits intervalles de temps, cinquante à dix mille accès utilisateur à des pages de la mémoire peuvent être effectués.

10. Système (400) selon l'une quelconque des revendications 1 à 9, dans lequel la mémoire (100 ; 401) comporte plusieurs portions (S_{i,j}) de plusieurs pages chacune, le système comportant des première (t1) et deuxième (t2) tables adaptées à mémoriser chacune autant d'entrées de 2 bits qu'une portion (S_{i,j}) comporte de pages (P_{i,j,k}).

11. Système (400) selon l'une quelconque des revendications 1 à 10, comportant en outre un dispositif (300) adapté à convertir des adresses logiques (301), qui sont les adresses utilisées par l'utilisateur pour accéder au contenu de la mémoire, en adresses physiques (301'), qui sont les adresses où sont effectivement mémorisés les contenus visés par l'utilisateur dans la mémoire.

12. Système (400) selon la revendication 11, dans lequel le dispositif (300) de conversion d'adresses comprend au moins un compteur ou registre de suivi de décalages de pages (P_{i,j,k}) à l'intérieur de la mémoire ou d'une portion de la mémoire.

13. Système (400) selon l'une quelconque des revendications 1 à 12, dans lequel le circuit de contrôle (403) comprend un premier sous-circuit adapté à mettre en oeuvre le procédé de gestion d'usure, ce sous-circuit étant intégré avec la mémoire (101) sur une même puce semiconductrice.

14. Système (400) selon l'une quelconque des revendications 1 à 12, dans lequel le circuit de contrôle (403) comprend un premier sous-circuit adapté à mettre en oeuvre le procédé de gestion d'usure, ce sous-circuit étant intégré dans une puce de circuit intégré distincte de la mémoire (101).

15. Système (400) selon l'une quelconque des revendications 1 à 14, dans lequel le procédé de gestion d'usure comprend un procédé de mesure d'usure comportant :
une première étape de lecture d'une page (P_{i,j,k}) dont on souhaite mesurer l'usure ;
une deuxième étape de lecture de ladite page (P_{i,j,k}) avec un seuil de discrimination entre les valeurs binaires '0' et '1' modifié par rapport à la première étape ; et
une étape de comparaison bit à bit des valeurs lues lors des première et deuxième étapes de lecture.

16. Système (400) selon l'une quelconque des revendications 1 à 15, dans lequel chaque cellule peut être programmée pour présenter soit un premier état de résistivité associé à une première valeur binaire soit un deuxième état plus fortement résistif associé à une deuxième valeur binaire, dans lequel le procédé de gestion d'usure comprend un procédé de réparation d'usure consistant à écrire et effacer alternativement une pluralité de fois une cellule mémoire jugée défectueuse, et/ou à réinitialiser cette cellule en lui appliquant une tension de même polarité qu'une tension normalement utilisée pour programmer cette cellule dans le premier état, mais de valeur supérieure.

## Patentansprüche

1. Ein System (400), das Folgendes aufweist:
ein nicht-flüchtiger resistiver Speicher (100; 401), der eine Vielzahl von Seiten (P_{i, j, k}) aufweist, und
eine Steuerschaltung (403) , die in der Lage ist Nutzerzugriffe auf den Speicher durchzuführen und ein Verfahren zum Management von Speicherabnutzung zu implementieren,
**dadurch gekennzeichnet, dass** die Steuerschaltung (403) eingerichtet ist zum Durchführen, zwischen ersten und zweiten aufeinanderfolgenden Operationen des Lesens oder Schreibens in eine Seite (P_{i, j, k}) des Verfahrens zum Ausgleichen von Abnutzung, und zwischen der zweiten Operation und einer darauffolgenden dritten Operation des Lesens oder Schreibens in eine Seite (P_{i, j, k}) des Verfahrens zum Ausgleichen von Abnutzung, und zwar Durchführen eines oder einer Vielzahl von Nutzerzugriffen auf die Seiten (P_{i, j, k}) des Speichers, wobei keine andere Operation des Lesens oder Schreibens in eine Seite des Verfahrens zum Ausgleichen von Abnutzung realisiert wird und zwar zwischen der ersten und zweiten Operation und zwischen der zweiten und dritten Operation,
und wobei das System ferner Zwischendatenspeicherelemente (REGA, REGB) aufweist, wobei die Steuerschaltung (403) eingerichtet ist, beim Implementieren des Verfahrens zum Management von Abnutzung, und zwar zum temporären Speichern von Speicherdaten in die Speicherelemente (REGA, REGB) und, wenn ein Lese- oder Schreib-Nutzerzugriff erfolgt, Verifizieren ob die Daten, auf die der Nutzer abzielt, in den Speicherelementen (REGA, REGB) enthalten sind und, falls sie das sind, Verarbeiten des Nutzerzugriffs direkt in den Speicherelementen (REGA, REGB).

2. Das System (400) nach Anspruch 1, das einen Zähler oder eine Tabelle (t1, t2) aufweist, die der Steuerschaltung (403) ermöglichen zu wissen, welche Speicheradressen durch das Verfahren zum Management von Abnutzung verarbeitet werden.

3. Das System (400) nach Anspruch 1 oder 2, wobei das Verfahren zum Management von Abnutzung ein Verfahren zum Ausgleichen von Abnutzung ist, das Datenverschiebungen aufweist, die im Modifizieren der physikalischen Adresse der Daten innerhalb des Speichers resultieren.

4. Das System (400) nach Anspruch 3, wobei die Zwischenspeicherelemente erste (REGA) und zweite (REGB) Register aufweisen, die jeweils in der Lage sind den Inhalt einer Speicherseite (P_{i, j, k}) zu speichern.

5. Das System (400) nach Anspruch 3 oder 4, wobei die Zwischenspeicherelemente (REGA, REGB) flüchtige Speicherelemente sind.

6. Das System (400) nach einem der Ansprüche 1 bis 5, wobei die Steuerschaltung (403) periodisch Abnutzungs-Management-Zyklen zum von einfügt und zwar zwischen Zyklen, die für Nutzerzugriffe reserviert sind, mit der Möglichkeit zum Durchführen einer Leseoperation oder einer Schreiboperation des Verfahrens zum Management von Abnutzung bei jedem Abnutzungs-Management-Zyklus.

7. Das System (400) nach einem der Ansprüche 1 bis 6, wobei die Steuerschaltung (403) in der Lage ist zum Durchführen der Nutzerzugriffe und der Operationen zum Lesen von und Schreiben in eine Seite (P_{i, j, k}) des Verfahrens zum Management von Abnutzung über einen gleichen Zugriffsanschluss (PT) des Speichers (401).

8. Das System (400) nach einem der Ansprüche 1 bis 7, wobei die Steuerschaltung (403) eingerichtet ist, so dass die aufeinanderfolgenden Lese-oder Schreib-Operationen des Verfahrens zum Ausgleich von Abnutzung getrennt sind und zwar durch zwei-mal-zwei Zeitabschnitte mit der gleichen Dauer.

9. Das System (400) nach Anspruch 8, wobei, in jedem der Zeitabschnitte zwischen fünfzig bis zehntausend Nutzerzugriffe auf die Speicherseiten durchgeführt werden können.

10. Das System (400) nach einem der Ansprüche 1 bis 9, wobei der Speicher (100; 401) eine Vielzahl von Bereichen (S_{i, j}) mit jeweils einer Vielzahl von Seiten aufweist, wobei das System erste (t1) und zweite (t2) Tabellen aufweist, die in der Lage sind so viele 2-bit Eingänge zu speichern, wie ein Bereich (S_{i, j}) Seiten (P_{i, j, k}) aufweist.

11. Das System (400) nach einem der Ansprüche 1 bis 10, das ferner ein Gerät (300) aufweist, das in der Lage ist logische Adressen (301) zu konvertieren, die die Adressen sind, welche von einem Nutzer verwendet werden um auf den Inhalt des Speichers zuzugreifen, und zwar in physikalische Adressen (301'), die die Adressen sind an welchen die Inhalte, auf die der Nutzer im Speicher abzielt, effektiv gespeichert sind.

12. Das System (400) nach Anspruch 11, wobei das Adressen-Konvertierungs-Gerät (300) wenigstens einen Zähler oder ein Register aufweist, und zwar zum Verfolgen von Verschiebungen von Seiten (P_{i, j, k}) innerhalb des Speichers oder eines Bereichs des Speichers.

13. Das System (400) nach einem der Ansprüche 1 bis 12, wobei die Steuerschaltung (403) eine erste Unter-Schaltung aufweist, die in der Lage ist das Verfahren zum Ausgleich von Abnutzung zu implementieren, wobei die Unter-Schaltung mit dem Speicher (101) auf einem gleichen Halbleiterchip integriert ist.

14. Das System (400) nach einem der Ansprüche 1 bis 12, wobei die Steuerschaltung (403) eine erste Unter-Schaltung aufweist, die in der Lage ist das Verfahren zum Ausgleich von Abnutzung zu implementieren, wobei die Unter-Schaltung auf einem anderen Halbleiterchip als der Speicher (101) integriert ist.

15. Das System (400) nach einem der Ansprüche 1 bis 14, wobei das Verfahren zum Management von Abnutzung ein Verfahren zum Messen von Abnutzung aufweist, das Folgendes aufweist:
ein erster Schritt des Lesens von einer Seite (P_{i, j, k}) deren Abnutzung gemessen werden soll;
ein zweiter Schritt des Lesens von der Seite (P_{i, j, k}) mit einem Schwellenwert zur Unterscheidung zwischen binären Werten '0' und '1' modifiziert bezüglich des ersten Schritts; und
ein Schritt mit Bit-zu-Bit Vergleich der Werte, die während der ersten und zweiten Lese-Schritten gelesen wurden.

16. Das System (400) nach einem der Ansprüche 1 bis 15, wobei das Verfahren zum Management von Abnutzung ein Verfahren zum Reparieren von Abnutzung aufweist, das abwechselnd Schreiben und Lesen aufweist, und zwar eine Vielzahl von Malen, in und von einer Speicherzelle, die als fehlerhaft angesehen wird, und/oder Zurücksetzen dieser Zelle aufweist, und zwar durch Anlegen einer Spannung daran mit gleichem Vorspannen wie eine Spannung, die normalerweise verwendet wird um diese Zelle in den leicht resistiven Zustand zu programmieren, aber mit einem größeren Wert.

## Claims

1. A system (400) comprising:
a non-volatile resistive memory (100; 401) comprising a plurality of pages (P_{i,j,k}); and
a control circuit (403) capable of performing user accesses to the memory and of implementing a memory wear management method,
**characterized in that** the control circuit (403) is configured for performing, between first and second consecutive operations of reading from or writing into a page (P_{i,j,k}) of the wear balancing method, and between the second operation and a third consecutive operation of reading from or writing into a page (P_{i,j,k}) of the wear balancing method, one or a plurality of user accesses to pages (P_{i,j,k}) of the memory, no other operation of reading or writing of a page of the wear balancing method being realized between the first and second operations and between the second and third operations,
an **in that** the system further comprised intermediate data storage elements (REGA, REGB), the control circuit (403) being configured for, on implementation of the wear management method, temporarily storing memory data into said storage elements (REGA, REGB) and, when a read or write user access occurs, verifying whether the data targeted by the user are contained in said storage elements (REGA, REGB) and, if they are, processing the user access directly in said storage elements (REGA, REGB).

2. The system (400) of claim 1, comprising a counter or a table (t1, t2) enabling the control circuit (403) to know which memory addresses are being processed by the wear management method.

3. The system (400) of claim 1 or 2, wherein the wear management method is a wear balancing method comprising data displacements resulting in modifying the physical address of the data within the memory.

4. The system (400) of claim 3, wherein said intermediate storage elements comprise first (REGA) and second (REGB) registers capable of each storing the content of a memory page (P_{i,j,k}).

5. The system (400) of claim 3 or 4, wherein said intermediate storage elements (REGA, REGB) are volatile memory elements.

6. The system (400) of any of claims 1 to 5, wherein the control circuit (403) periodically inserts wear management cycles between memory cycles reserved to user accesses, with the possibility of performing a read operation or a write operation of the wear management method at each wear management cycle.

7. The system (400) of any of claims 1 to 6, wherein the control circuit (403) is capable of performing said user accesses and said operations of reading from and writing into a page (P_{i,j,k}) of the wear management method via a same access port (PT) of the memory (401).

8. The system (400) of any of claims 1 to 7, wherein the control circuit (403) is configured so that the consecutive read or write operations of the wear balancing method are separated two by two by time intervals having the same duration.

9. The system (400) of claim 8, wherein, in each of said time intervals, from fifty to ten thousand user accesses to memory pages may be performed.

10. The system (400) of any of claims 1 to 9, wherein the memory (100; 401) comprises a plurality of portions (S_{i,j}) of a plurality of pages each, the system comprising first (t1) and second (t2) tables capable of storing as many 2-bit inputs as a portion (S_{i,j}) comprises pages (P_{i,j,k}).

11. The system (400) of any of claims 1 to 10, further comprising a device (300) capable of converting logic addresses (301), which are the addresses used by the user to access the content of the memory, into physical addresses (301'), which are the addresses where the contents targeted by the user in the memory are effectively stored.

12. The system (400) of claim 11, wherein the address conversion device (300) comprises at least one counter or register for tracking shifts of pages (P_{i,j,k}) within the memory or a portion of the memory.

13. The system (400) of any of claims 1 to 12, wherein the control circuit (403) comprises a first sub-circuit capable of implementing the wear balancing method, this sub-circuit being integrated with the memory (101) on a same semiconductor chip.

14. The system (400) of any of claims 1 to 12, wherein the control circuit (403) comprises a first sub-circuit capable of implementing the wear balancing method, this sub-circuit being integrated in a different integrated circuit chip than the memory (101) .

15. The system (400) of any of claims 1 to 14, wherein the wear management method comprises a wear measurement method comprising:
a first step of reading from a page (P_{i,j,k}) having its wear desired to be measured;
a second step of reading from said page (P_{i,j,k}) with a threshold of discrimination between binary values '0' and '1' modified with respect to the first step; and
a step of bit-to-bit comparison of the values read during the first and second reading steps.

16. The system (400) of any of claims 1 to 15, wherein the wear management method comprises a wear repair method comprising alternately writing and deleting, a plurality of times, into and from a memory cell deemed defective, and/or resetting this cell by applying thereto a voltage of same biasing as a voltage normally used to program this cell to the lightly resistive state, but of greater value.
